# EUROPÄISCHE PATENTANMELDUNG

(11) **EP 0 768 575 A2**
(43) Veröffentlichungstag der Anmeldung: **16.04.1997**
(21) Anmeldenummer: 96113463.2
(22) Anmeldetag: 22.08.1996
(51) Int. Cl.: G03F 7/20

(54) **Verfahren zum Optimieren einer Anordnung von Halbleiterelementen auf einem Halbleiterwafer**

(30) Priorität: 10.10.1995 DE 19537756
(71) Anmelder: Deutsche ITT Industries GmbH, 79108 Freiburg (DE)
(72) Erfinder: Stroh, Rüdiger Joachim, Dipl.-Ing., 79098 Freiburg (DE); Kunert, Detlef, Dipl.-Ing., 79211 Denzlingen (DE)

(57) **Zusammenfassung**

Halbleiterwafer 1, bei dem Halbleiterelemente 3 mittels einer Maske auf den Wafer 1 belichtet werden, wobei die Justierung der Maske über einen Bezugspunkt auf der Maske und einen Referenzpunkt auf dem Wafer 1 erfolgt, deren räumliche Lage zueinander mittels eines Verfahrens zur Optimierung von Größen, die die Herstellungskosten eines Halbleiterelements 3 bestimmen, ermittelt wird.

## Beschreibung

Die Erfindung betrifft ein Verfahren zum Optimieren einer Anordnung von Halbleiterelementen, insbesondere IC Elementen, auf einem mit einem lichtempfindlichen Lack beschichteten Halbleiterwafer, bei dem die Halbleiterelemente mittels einer Maske auf den Wafer belichtet werden.

Ein derartiges Verfahren ist aus der DE 32 47 141 bekannt. Bei diesem Verfahren wird das Problem berücksichtigt, daß auf einem Wafer bestimmte Flächenbereiche vorgesehen sein können, auf denen keine Halbleiterelemente aufgebracht werden sollen. Solche Flächenelemente dienen in der Regel zum Aufbringen von Teststrukturen, die seitens des Herstellers wünschenswert sind oder zum Justieren der Belichtungsmaschine benötigt werden. Um den Verlust der Waferfläche im Bereich um diese Teststrukturen zu verringern, werden die aufzubelichtenden Strukturen, d.h. die Stepfelder relativ zueinander so variiert, daß keine leeren Stellen um die freizuhaltenden Flächenbereiche bestehen bleiben.

Es gibt Verfahren, bei denen eine Maske hergestellt wird, mittels der bei einer Belichtung alle Halbleiterelemente gleichzeitig auf den Wafer berichtet werden. Bei anderen Verfahren umfaßt eine Maske ein Stepfeld von Halbleiterelementen. In diesem Fall erfolgt die Belichtung mit einer Steppervorrichtung, mit der die Stepfelder, die eine bestimmte Anzahl von Halbleiterelementen enthalten, schrittweise nacheinander mittels der Maske auf den Wafer berichtet werden. Nach dieser Belichtung wird der Lack entwickelt. Danach wird ein vorbestimmter Prozeß durchgeführt, wie Ätzen, Implantieren von Ionen etc.. Nach diesem Prozeßschritt wird der Lack von dem Halbleiterwafer entfernt, wonach der erste Strukturierungsschritt des Halbleiter-Herstellungsprozesses beendet ist. Auf die gleiche Art und Weise werden weitere Strukturierungsschritte vorgenommen, bei denen die Maske zur Erzeugung der Stepfeldanordnung wie die entsprechende Maske bei dem ersten Strukturierungsschritt justiert werden muß. Die Maske, die bei dem ersten Strukturierungsschritt verwendet wird, wird üblicherweise so justiert, daß ihre Längsachse mit der Längsachse des Halbleiterwafers zusammenfällt und sie in Richtung der Längsachse so verschoben wird, daß die Maske nicht zu belichtende Bereiche des Wafers nicht überlappt.

Der Erfindung liegt die Aufgabe zugrunde, ein Verfahren zu schaffen, bei dem die Herstellungskosten pro Halbleiterelement verringert werden können.

Diese Aufgabe wird durch ein gattungsgemäßes Optimierungsverfahren gelöst, bei dem die Justierung der Maske über einen Bezugspunkt auf der Maske und einen Referenzpunkt auf dem Wafer erfolgt, deren räumliche Läge zueinander mittels eines Verfahrens zur Optimierung von Größen, die die Herstellungskosten eines Halbleiterelements bestimmen, ermittelt wird, wobei die Läge der Halbleiterelemente relativ zueinander während der Optimierung fest bleibt.

Bei dem erfindungsgemäßen Verfahren erfolgt die Justierung der Maske auf dem Wafer nicht, wie es bisher üblich war, derart, daß die möglichst symmetrisch zu dem Mittelpunkt des Wafers ausgerichtet wird. Es wird erfindungsgemäß vielmehr vor der Justierung ein Optimierungsverfahren durchgeführt. Mit dem Verfahren werden die Größen optimiert, die die Herstellungskosten eines Halbleiterelements bestimmen. Durch diese Optimierung wird dann die Justierung festgelegt, so daß durch eine effektivere Belichtung des Wafers Herstellungskosten pro Halbleiterelement gespart werden können. Besonders vorteilhaft ist das Verfahren bei großen Halbleiterelementen, wie IC (Integrierte Schaltungs-)Elemente.

Nach einem ersten Ausführungsbeispiel der Erfindung wird die Optimierung vor der Herstellung der Maske durchgeführt. Dabei wird gleichzeitig die, durch die auf den Wafer zu belichtenden Halbleiterelemente, gegebene Form der Maske bestimmt. Dies ist dann vorteilhaft, wenn nur eine Maske zum Aufbelichten aller Halbleiterelemente bei einem Belichtungsvorgang verwendet wird. In diesem Fall wird bei der Optimierung die Form der gesamten Maske festgelegt. Diese liegt dann fest, wenn die Position der Maske auf dem Wafer bestimmt ist und dadurch festgelegt ist, welche Halbleiterelemente nicht auf die zu belichtenden Bereiche des Wafers passen und damit von der Maske ausgeschlossen werden.

Bei einem zweiten Ausführungsbeispiel der Erfindung wird die Maske zum Aufbelichten eines Stepfeldes von Halbleiterelementen ausgebildet, wobei ein Stepfeld mindestens ein Halbleiterelement umfaßt, und die Stepfelder mittels der Maske nacheinander auf den Wafer belichtet werden. Bei dieser Stepfeldanordnung liegt die Form der Maske fest. Sie ist durch die Anzahl und Anordnung der Halbleiterelemente gegeben. Die Stepfelder werden dann nacheinander in Stepperschritten auf den Halbleiterwafer belichtet. Die Optimierung wird vorteilhafterweise vor der ersten Belichtung mit der Maske durchgeführt. Die Position der Maske für die darauffolgenden Stepperschritte ist dann bereits festgelegt. Zur Durchführung des Optimierungsverfahrens wird selbstverständlich das Raster der gesamten auf dem Wafer anzuordnenden Halbleiterelemente berücksichtigt.

Gemäß einem bevorzugten Ausführungsbeispiel der Erfindung ist eine Größe die Anzahl der auf dem Wafer anordenbaren Halbleiterelemente, wobei zur Optimierung deren maximale Anzahl bestimmt wird. Es wurde experimentell festgestellt, daß bei dieser Optimierung eine deutlich größere Anzahl von Halbleiterelementen auf den Wafer aufgebracht werden können als dies bei einer symmetrischen Anordnung der Maske auf dem Wafer gemäß dem Stand der Technik der Fall ist. Durch das Optimierungsverfahren werden somit die Prozeßkosten pro Halbleiterelement entsprechend reduziert.

Gemäß einem weiteren Ausführungsbeispiel der Erfindung ist eine Größe die Anzahl der Stepfelder, wobei zur Optimierung deren minimale Anzahl bestimmt wird. Es wurde experimentell festgestellt, daß dadurch die Anzahl der Stepfelder und damit die Anzahl der Schritte, die die Steppervorrichtung zur Belichtung des Wafers durchführen muß, im Vergleich zu der herkömmlichen symmetrischen Anordnung deutlich reduziert werden kann. Da die Anzahl der Schritte der Steppervorrichtung die Prozeßzeit und damit die Prozeßkosten für die Herstellung des Wafers mit den Halbleiterelementen bestimmt, werden durch eine Reduktion der auszuführenden Stepperschritte die Herstellungskosten pro Wafer und pro hergestelltem Halbleiterelement deutlich reduziert. Dies macht sich insbesondere dann bemerkbar, wenn bei einem bestimmten Prozeß das Aufbelichten der Halbleiterelemente auf den Lack sehr teuer ist. Abhängig davon, was für ein Prozeß zum Aufbelichten der Halbleiterelemente durchgeführt wird, kann die Stepfeldanordnung dadurch bestimmt werden, daß nur die Anzahl der Stepfelder minimiert wird, daß nur die Anzahl der auf den Wafer anordenbaren Halbleiterelemente maximiert wird oder daß beide Parameter gleichzeitig optimiert werden. Welches Verfahren bei den gegebenen Prozeßbedingungen die meisten Kosten spart, kann der Fachmann im Einzelfall bestimmen.

Ferner ist es günstig, wenn das Optimierungsverfahren mit durch den Herstellungsprozeß bestimmten Randbedingungen durchgeführt wird. Durch derartige Randbedingungen können weiter Kosten reduziert werden. Als Randbedingungen können auf dem Wafer Ausschlußbereiche, auf die keine Stepfelder belichtet werden, bzw. Belichtungsbereiche, auf die Stepfelder in jedem Falle belichtet werden sollen, bzw. Testbereiche, auf die Teststrukturen belichtet werden, bestimmt werden. Welche dieser Randbedingungen bei einem gegebenen Prozeß vorteilhaft sind, kann der Fachmann im Einzelfall bestimmten. Das Bestimmen von Ausschlußbereichen ist dann vorteilhaft, wenn bestimmte Bereiche, beispielsweise zur Beschriftung, zum Anfassen des Wafers etc., nicht dazu verwendet werden sollen, Halbleiterelemente aufzubringen. Es können auch Bereiche ausgeschlossen werden, bei denen zu erwarten ist, daß dort aufgebrachte Halbleiterelemente fehlerhaft sind oder eine schlechte Qualität aufweisen, so daß sie nicht verwendet werden sollen. Ein Grund dafür kann die schlechtere Qualität des aufgebrachten photosensitiven Lacks, insbesondere in Randbereichen des Wafers, sein. Wenn auf diese Ausschlußbereiche keine Halbleiterelemente belichtet werden, wird die Prozeßzeit und damit die Prozeßkosten weiter reduziert. Als Belichtungsbereiche können Bereiche gewählt werden, bei denen eine Belichtung notwendig ist, beispielsweise um eine Stabilität des auf den Wafer aufgebrachten Lacks zu gewährleisten. Dies ist insbesondere dann vorteilhaft, wenn bei einer bestimmten Lackart auf einem bestimmten Wafermaterial die Gefahr besteht, daß der Lack, wenn er großflächig ohne Strukturierung aufgebracht ist, leicht absplittert. Das Aufbringen von Testbereichen ist dann vorteilhaft, wenn bei bestimmten Prozessen Teststrukturen erforderlich sind, um den Prozeß auszuführen oder zu kontrollieren.

Günstigerweise wird bei Bestimmung mehrerer Stepfeldanordnungen mit gleichen optimierten Größen die Anordnung gewählt, bei der der Abstand der Halbleiterelemente zum Waferrand maximal ist. Somit werden die Halbleiterelemente auf den Bereich des Wafers aufgebracht, wo die Lackbedingungen und somit die Bedingungen für gut funktionierende, fehlerfreie Halbleiterelemente am besten sind.

Vorteilhafterweise wird das Verfahren zur Optimierung mittels eines Computers durchgeführt. Hierdurch wird eine sehr präzise Optimierung der Stepfeldanordnung möglich. Es können alle möglichen Anordnungen der Halbleiterelemente auf dem Wafer bzw. der Stepfeldanordnungen durchprobiert werden.

Eine weitere Größe zum Optimieren kann das Seiten/Längenverhältnis der Stepfelder sein, wobei die Halbleiterelemente entsprechend zu Stepfeldern gruppiert werden. Hierzu kann bei gegebener Anzahl der Halbleiterelemente die Anzahl der Stepfelder verringert werden.

Als weitere Größe kann das Seiten/Längenverhältnis bzw. die Fläche der Halbleiterelemente, insbesondere der IC-Elemente optimiert werden. Die IC-Elemente können dabei beispielsweise um 90° C gedreht werden, falls in dieser Anordnung mehr IC-Elemente auf den Wafer aufgebracht werden können. Auch durch Änderung der Fläche der IC-Elemente kann ihre Anzahl auf dem Wafer maximiert werden. Es wurde ermittelt, daß es auch Fälle gibt, bei denen bei einer größeren Fläche der IC-Elemente bei einem geeigneten Längen/Seitenverhältnis mehr IC-Elemente auf den Wafer aufgebracht werden können als bei einer kleineren Fläche. Es kann ferner die Anordnung der Schaltblöcke eines IC-Elements so lange variiert werden, bis das dem berechneten nächstkommende Seiten/Längenverhältnis der IC-Elemente erreicht wird.

Zur Optimierung der Größen, die die Herstellungskosten eines IC's bestimmen, kann mittels einer rechnerischen Simulation die Maske relativ zu dem Wafer schrittweise verschoben werden, die relative Position über die relative Lage von Referenzpunkt zu Bezugspunkt bestimmt werden, die größenabhängig von der Position gespeichert und für verschiedene Positionen miteinander verglichen werden. Dies ist ein zuverlässiges Verfahren zum Optimieren der Stepfeldanordnung. Im folgenden wird die Erfindung anhand der Figuren näher erläutert.

Es zeigen:
Fig. 1 eine optimierte Stepfeldanordnung gemäß der Erfindung und
Fig. 2 eine herkömmliche Stepfeldanordnung für die gleichen IC-Elemente auf dem gleichen Wafer.

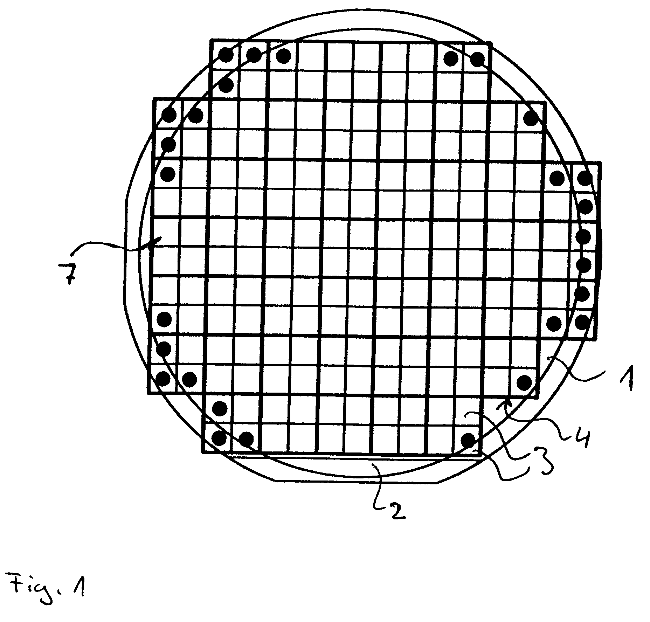

Fig. 1 zeigt eine mit dem erfindungsgemäßen Verfahren optimierte Stepfeldanordnung auf einem Wafer 1. Der Wafer 1 umfaßt ein Ausschlußbereich 2, der zur Beschriftung freigehalten und auf den daher keine IC-Elemente aufgebracht werden. Auf dem Wafer 1 sind IC-Elemente 3 aufgebracht, die in Stepfeldern 4 angeordnet sind. Die mit dem Symbol "●" gekennzeichneten IC-Elemente 3 sind die IC-Elemente, die aufgrund von schlechten Prozeßbedingungen, d.h. hier daß sie zu nahe am Rande des Wafers 1 liegen, nicht in der Anwendung nach der Produktion verwendet werden.

Im folgenden wird ein Ausführungsbeispiel des erfindungsgemäßen Verfahrens, mit dem das Ergebnis der Figur 1 erzielt wurde, beschrieben. Auf den Wafer 1 wird mit einem dem Fachmann bekannten Verfahren ein lichtempfindlicher Lack, welcher für die Prozeßbedingungen geeignet gewählt wird, aufgebracht. Vor dem Belichten des Wafers 1 wird mit einem Computer eine Optimierung der auf den Wafer 1 aufzubringenden Stepfeldanordnung 6 durchgeführt. Hierzu werden dem Computer die notwendigen Randbedingungen zugeführt. Diese sind der Durchmesser des Wafers 1, Längen/Seitenverhältnis der IC-Elemente, Längen/Seitenverhältnis der Stepfelder, der Ausschlußbereich 2, auf den keine Stepfelder 4 berichtet werden sollen sowie eine Randzone des Wafers 1, auf welche IC-Elemente belichtet werden sollen, die aber nicht verwendet werden sollen. Mittels des Computers wird dann eine Simulation durchgeführt. Zunächst wird die Anzahl der IC-Elemente 3, die weiterverwendet werden können, auf der Fläche des Wafers 1 außerhalb des Ausschlußbereichs 2 maximiert. Hierzu werden die IC-Elemente 3 zunächst so auf die zur Verfügung stehende Waferfläche 7 aufgebracht, daß die Anordnung der IC-Elemente 3 symmetrisch zu dem Mittelpunkt des Wafers 1 ist. Es wird die Anzahl der verwertbaren IC-Elemente 6 bestimmt. Dann wird die gesamte Anordnung der IC-Elemente hinsichtlich des Mittelpunktes des Wafers 1 nach einem vorgegebenen System sowohl in x- als auch in y-Richtung verschoben. In jeder dieser Positionen wird die Anzahl der auf die Waferfläche 7 passenden IC-Elemente 3, die verwendet werden können, bestimmt und gespeichert.

Durch Vergleich der Anzahl dieser IC-Elemente für die verschiedenen Positionen wird die Position der Maske mit der maximalen Anzahl solcher IC-Elemente 3 bestimmt.

Danach werden die verschiedenen Möglichkeiten zur Gruppierung der IC's dieser IC-Anordnung zu Stepfeldern simuliert. Für jede Möglichkeit wird die Anzahl der Stepfelder bestimmt. Durch Vergleich wird die minimale Anzahl bestimmt. Das Ergebnis ist die Stepfeldanordnung der Fig. 1. Es können dort 164 IC-Elemente 6 aufgebracht werden. Die Anzahl der Stepperschritte beträgt 49.

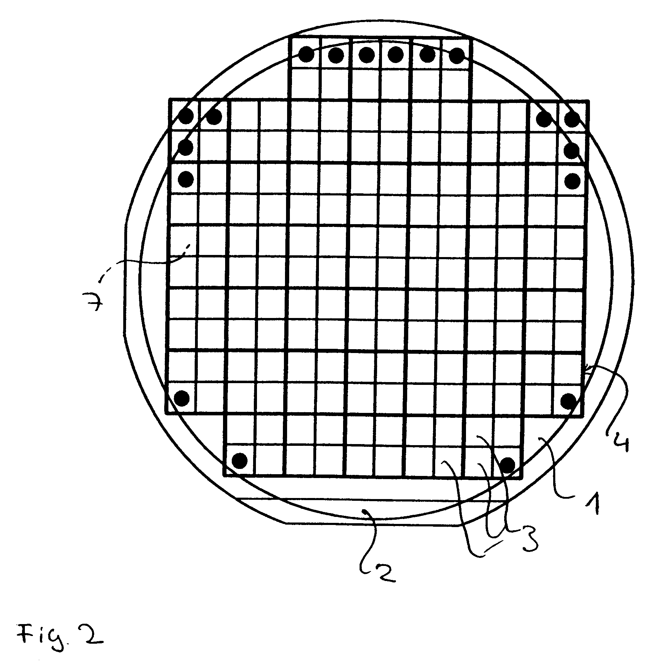

Im Vergleich dazu zeigt Fig. 2 eine Anordnung, die unter den gleichen Randbedingungen, d.h. Waferdurchmesser, Längen/Seitenverhältnis der Chipelemente, Länge/Seitenverhältnis der Stepfelder und Ausschlußbereich 2, nach einem herkömmlichen Verfahren, also ohne Optimierung, auf den Wafer aufgebracht wurde. Die Maske für die Belichtung wurde dabei lediglich in y-Richtung so verschoben, daß die IC-Elemente 6 nicht auf den Ausschlußbereich 2 belichtet werden. Die Anordnung der IC-Elemente 6 bzw. die Stepfeldanordnung ist dabei symmetrisch zu der y-Achse des Wafers 1 durch den Wafermittelpunkt. Trotz der Symmetrie werden in diesem Fall erheblich weniger IC-Elemente auf den Wafer 1 aufgebracht. Die Anzahl der IC-Elemente 6, die weiterverwendet werden können, beträgt dort 154. Die Anzahl der Stepperschritte, die erforderlich sind, um die IC-Elemente 6 auf den Wafer 1 aufzubelichten beträgt 43. In dem gezeigten Beispiel können also ca. 10 % mehr IC-Elemente auf einen Wafer aufgebracht werden. Hierdurch werden die Herstellungskosten pro IC-Element erheblich reduziert.

Nach der Bestimmung der optimierten Stepfeldanordnung wird der Wafer 1 mittels der Steppervorrichtung schrittweise in der vorgegebenen Art und Weise belichtet. Hierzu werden vor dem Belichtungsvorgang die erforderlichen Angaben, insbesondere die Lage des Bezugspunktes auf der Maske zu dem Referenzpunkt auf dem Wafer, der Steppervorrichtung zugeführt. Danach folgen die üblichen Herstellungsschritte. Der belichtete Lack wird entwickelt, der gewünschte Prozeßschritt, wie Oxydation, Implantation von Ionen etc., wird durchgeführt und der restliche Lack wird von dem Wafer entfernt. Damit ist der erste Strukturierungsschritt beendet. Die weiteren Strukturierungsschritte werden wie üblich vorgenommen, wobei die Justierung der Belichtungsmaske jeweils über die in dem ersten Schritt bestimmte relative Lage des Bezugspunktes auf der Maske zu dem Referenzpunkt auf dem Wafer erfolgt.

Das oben beschriebene Ausführungsbeispiel des Verfahrens ist ein Ausführungsbeispiel der Erfindung. Es sind abhängig von den Prozeßbedingungen viele weitere Ausführungsbeispiele denkbar. Auch kann der Ablauf und die Durchführung des Optimierungsverfahrens variiert werden. Die Einzelheiten der verschiedenen Ausführungsarten sind dem Fachmann überlassen.

## Patentansprüche

1. Verfahren zum Optimieren einer Anordnung (6) von Halbleiterelementen (3), insbesondere IC-Elementen, auf einem mit einem lichtempfindlichen Lack beschichteten Halbleiterwafer (1), bei dem die Halbleiterelemente (3) mittels einer Maske auf den Wafer (1) belichtet werden, dadurch gekennzeichnet, daß die Justierung der Maske über einen Bezugspunkt auf der Maske und einen Referenzpunkt auf dem Wafer (1) erfolgt, deren räumliche Lage zueinander mittels eines Verfahrens zur Optimierung von Größen, die die Herstellungskosten eines Halbleiterelements (3) bestimmen, ermittelt wird, wobei die Lage der Halbleiterelemente (3) relativ zueinander während der Optimierung festbleibt.

2. Verfahren nach Anspruch 1, dadurch gekennzeichnet, daß die Optimierung vor der Herstellung der Maske durchgeführt wird und dabei gleichzeitig die durch die auf den Wafer zu belichtenden Halbleiterelemente gegebene Form der Maske bestimmt wird.

3. Verfahren nach Anspruch 1, daß die Maske zum Aufbelichten eines Stepfeldes von Halbleiterelementen ausgebildet ist, wobei ein Stepfeld mindestens ein Halbleiterelement umfaßt, und die Stepfelder mittels der Maske nacheinander auf den Wafer belichtet werden.

4. Verfahren nach Anspruch 3, daß die Optimierung vor der ersten Belichtung mit der Maske durchgeführt wird.

5. Verfahren nach einem der vorangehenden Ansprüche, dadurch gekennzeichnet, daß eine Größe die Anzahl der auf dem Wafer (1) anordenbaren Halbleiterelemente (3) ist, und zur Optimierung deren maximale Anzahl bestimmt wird.

6. Verfahren nach einem der vorangehenden Ansprüche, dadurch gekennzeichnet, daß eine Größe die Anzahl der Stepfelder ist, und zur Optimierung deren minimale Anzahl bestimmt wird.

7. Verfahren nach einem der vorangehenden Ansprüche, dadurch gekennzeichnet, daß das Optimierungsverfahren mit durch den Herstellungsprozeß bestimmten Randbedingungen durchgeführt wird.

8. Verfahren nach Anspruch 7, dadurch gekennzeichnet, daß als Randbedingung auf dem Wafer (1) Ausschlußbereiche (2), auf die keine Stepfelder (4) belichtet werden, bzw. Belichtungsbereiche, auf die Stepfelder in jedem Falle belichtet werden sollen, bzw. Testbereiche, auf die Teststrukturen belichtet werden, bestimmt werden.

9. Verfahren nach einem der vorangehenden Ansprüche, dadurch gekennzeichnet, daß bei Bestimmung mehrerer Stepfeldanordnungen (4) mit gleichen optimierten Größen die Anordnung gewählt wird, bei der der Abstand der Halbleiterelemente (3) zum Waferrand maximal ist.

10. Verfahren nach einem der vorangehenden Ansprüche, dadurch gekennzeichnet, daß das Verfahren zur Optimierung mittels eines Computers durchgeführt wird.

11. Verfahren nach einem der Ansprüche 6 bis 10, dadurch gekennzeichnet, daß eine weitere Größe das Seiten/Längenverhältnis der Stepfelder ist und die Halbleiterelemente (3) entsprechend zu Stepfeldern (4) gruppiert werden.

12. Verfahren nach einem der Ansprüche 5 bis 9, dadurch gekennzeichnet, daß eine weitere Größe das Seiten/Längenverhältnis bzw. die Fläche der IC-Elemente (3) ist.

13. Verfahren nach Anspruch 12, dadurch gekennzeichnet, daß die Anordnung der Schaltblöcke eines IC-Elements (3) so lange variiert wird, bis das dem berechneten nächstkommende Seiten/Längenverhältnis der IC-Elemente (3) erreicht wird.

14. Verfahren nach einem der Ansprüche 10 bis 13, dadurch gekennzeichnet, daß zur Optimierung der Größen, die die Herstellungskosten eines Halbleiterelements (3) bestimmen, mittels einer rechnerischen Simulation die Maske relativ zu dem Wafer (1) schrittweise verschoben wird, die relative Position über die relative Lage von Referenzpunkt zu Bezugspunkt bestimmt wird, die größenabhängig von der Position gespeichert und für verschiedene Positionen miteinander verglichen werden.
